# EUROPEAN PATENT APPLICATION

(11) **EP 1 628 391 A2**
(43) Date of publication of application: **22.02.2006**
(21) Application number: 05005616.7
(22) Date of filing: 15.03.2005
(51) Int. Cl.: H03D 7/00, H04B 1/16

(54) **Front-end circuit for a receiver**

(30) Priority: 19.08.2004 JP 2004239483
(71) Applicant: MATSUSHITA ELECTRIC INDUSTRIAL CO., LTD., Kadoma-shi, Osaka 571-8501 (JP)
(72) Inventor: Ishida, Kaoru, Shijonawate-shi, Osaka 575-0013 (JP); Komori, Hiroshi, Otsu-shi, Shiga 520-2132 (JP)
(74) Representative: Grünecker, Kinkeldey, Stockmair & Schwanhäusser Anwaltssozietät

(57) **Abstract**

An average level detection circuit (10) outputs a level of an input signal of a baseband output signal or a mixer circuit. A smoothing circuit (11) removes an AC component from an output signal of the average level detection circuit (10). A reference comparison circuit (12) outputs a level suppression signal when an output signal of the smoothing circuit (11) exceeds a predetermined reference voltage. When the reference comparison circuit (12) outputs the level suppression signal, the limiter circuit (13) controls the bias circuit (14) to suppress a bias current of the mixer circuit. As a result, it is possible to obtain a low-current-consumption signal reception front-end circuit in which an IF output level is not significantly lowered under an unexpectedly strong input condition, and a signal reception circuit in which an error does not occur in signal reception level detection.

## Description

### BACKGROUND OF THE INVENTION

### Field of the Invention

The present invention relates to a signal reception circuit for use in a mobile communication apparatus or the like, and a signal reception front-end circuit contained in the same.

### Description of the Background Art

Recently, a study is being made of construction of a wireless circuit using a semiconductor integrated circuit in order to reduce the size of a mobile communication apparatus. Also in order to reduce the power consumption of a wireless circuit, a technology of sharing a current among a plurality of circuit blocks, a technology of expanding a dynamic range at low voltage, and the like have been studied.

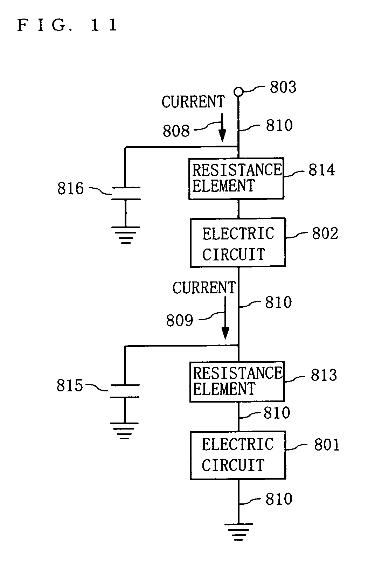

FIG. 11 is a diagram showing a circuit disclosed in Japanese Patent Laid-Open Publication No. H5-37245, in which a current is shared among a plurality of circuit blocks. In the circuit of FIG. 11, an electric circuit 802 is connected via a power source line 810 and a resistance element 814 to a power source 803. Also, a power source line 810 of an electric circuit 801 is connected via a resistance element 813 to a side to be grounded of the electric circuit 802. In this manner, the two electric circuits 801 and 802 are driven using a common current 808, 809, thereby making it possible to reduce a current consumed by the circuit.

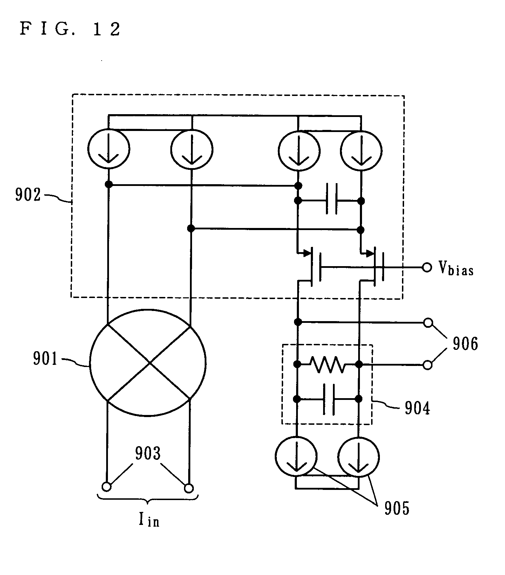

FIG. 12 is a diagram showing a folded load downconverter circuit described in IEEE Journal of Solid-State Circuits, Vol. 37, No. 12, pp. 1710-1720. In the circuit of FIG. 12, a signal Iᵢₙ which is input through an input terminal 903 is frequency-converted by a mixer circuit 901. The converted signal is folded as a current signal by an action of a folded current mirror circuit 902. The folded signal is converted back to a voltage signal by a load circuit 904, and thereafter, is output through an IF (Intermediate Frequency) output terminal 906. As a result, a dynamic range of voltage can be secured using a lower current than when the mixer circuit 901 and the load circuit 904 are vertically stacked.

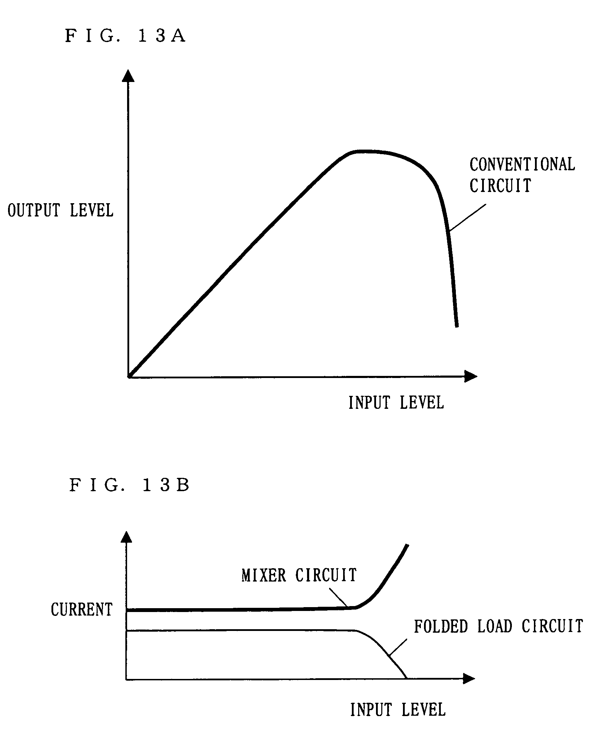

However, for example, when a mobile communication apparatus is in an initial state when powered on or is moved from behind a building to a place within sight of a base station, the mobile communication apparatus may receive an unexpectedly strong signal since the gain of the signal reception circuit has been set to be high. Under such an unexpectedly strong input condition, a current of the mixer circuit increases in association with a saturated operation of the circuit. In the above-described conventional circuit, the sum of a current flowing through the mixer circuit and a current flowing through the folded load circuit is constant due to an action of the folded current mirror circuit. Therefore, an increase in the current flowing through the mixer circuit corresponds to a decrease in the current flowing through the folded load circuit (see FIGS. 13A and 13B). As a result, the circuit can no longer operate, so that an IF output level is significantly reduced. Further, the significant decrease of the IF output level leads to occurrence of a large error in a signal reception level which is detected using the IF output level.

### SUMMARY OF THE INVENTION

Therefore, an object of the present invention is to provide a low-current-consumption signal reception front-end circuit in which an IF output level is not significantly lowered under an unexpectedly strong input condition, and a signal reception circuit in which an error does not occur in signal reception level detection.

The present invention has the following features to attain the object mentioned above.

To achieve the object, a signal reception front-end circuit of the present invention comprises a folded load downconverter circuit comprising a mixer circuit, a current mirror circuit and a load circuit, in which the current mirror circuit folds an output of the mixer circuit, and the load circuit is connected to a folded output of the current mirror circuit, a detection circuit of detecting an input signal or an output signal of the folded load downconverter circuit, a smoothing circuit of smoothing an output signal of the detection circuit, a reference comparison circuit of comparing an output signal of the smoothing circuit with a predetermined reference voltage, and a bias control circuit of controlling a bias of the folded load downconverter circuit, depending on a result of comparison by the reference comparison circuit.

In the signal reception front-end circuit, the bias control circuit may control a bias of the mixer circuit or the current mirror circuit. The detection circuit may be connected to an input of the mixer circuit or an output of the load circuit. The detection circuit may detect an AC amplitude and/or a DC level of a signal. The reference voltage may be switched among a plurality of levels. When the reference voltage is switched, a cut-off frequency of the smoothing circuit may be switched.

The folded load downconverter circuit may be a multiple-input single-output circuit comprising the load circuit, a plurality of the mixer circuits and a plurality of the current mirror circuits, in which the current mirror circuits fold outputs of the respective mixer circuits, folded outputs of the current mirror circuits are connected to a common output, and the load circuit is connected to the common output. The signal reception front-end circuit may comprise a plurality of the bias control circuits. The bias control circuits may control biases of the respective folded load downconverter circuits provided for input signals. In this case, the bias control circuits may control biases of the respective mixer circuits or the respective current mirror circuits. The signal reception front-end circuit may comprise a plurality of the detection circuits. The detection circuits are connected to inputs of the respective mixer circuits. Alternatively, the detection circuit may be connected to an output of the load circuit.

A signal reception circuit of the present invention comprises a gain switch circuit of regulating a level of a received signal, and the above-described signal reception front-end circuit connected to an output of the gain switch circuit. In the signal reception circuit, a gain of the gain switch circuit may be switched to a low value during a time when the bias control circuit suppresses a bias. The gain switch circuit may comprise a variable gain amplifier or a variable attenuator. Alternatively, the gain switch circuit may comprise a fixed gain amplifier, and a bypass circuit of causing a signal to bypass the fixed gain amplifier in the case of a low gain. The signal reception circuit may further comprise a variable gain amplifier of amplifying an output signal of the signal reception front-end circuit. A gain of the variable gain amplifier may be switched with the same timing as a timing with which a gain of the gain switch circuits is changed.

The signal reception circuit may comprise a plurality of the gain switch circuits. The folded load downconverter circuit may be the above-described multiple-input single-output circuit comprising the load circuit. The signal reception front-end circuit may comprise a plurality of the bias control circuits. The bias control circuits may control biases of the respective folded load downconverter circuits provided for input signals. In this case, at least one of the gain switch circuits may comprise a variable gain amplifier or a variable attenuator. Alternatively, at least one of the gain switch circuits may comprise a fixed gain amplifier, and a bypass circuit of causing a signal to bypass the fixed gain amplifier in the case of a low gain.

A communication apparatus of the present invention comprises an antenna of transmitting/receiving a radio wave, an antenna-sharing circuit connected to the antenna, a transmission circuit connected to the antenna-sharing circuit, and the above-described signal reception circuit connected to the antenna-sharing circuit.

In the signal reception front-end circuit of the present invention, a current flowing through the load circuit does not become zero under an unexpectedly strong input condition. Therefore, it is possible to obtain a low-current-consumption signal reception front-end circuit in which the IF output level does not significantly decrease under the unexpectedly strong input condition. The signal reception circuit and the communication apparatus of the present invention each comprise a signal reception front-end circuit in which an IF output level does not significantly decrease under an unexpectedly strong input condition. Therefore, it is possible to obtain a low-current-consumption signal reception circuit and communication apparatus which do not malfunction under the unexpectedly strong input condition.

These and other objects, features, aspects and advantages of the present invention will become more apparent from the following detailed description of the present invention when taken in conjunction with the accompanying drawings.

### BRIEF DESCRIPTION OF THE DRAWINGS

FIG. 1 is a block diagram of a structure of a signal reception front-end circuit according to a first embodiment of the present invention,
FIGS. 2A and 2B are diagrams of characteristics of the signal reception front-end circuit of the first embodiment of the present invention,
FIG. 3 is a block diagram of a signal reception front-end circuit according to a second embodiment of the present invention,
FIG. 4 is a block diagram of a signal reception front-end circuit according to a third embodiment of the present invention,
FIG. 5 is a block diagram of a signal reception front-end circuit according to a fourth embodiment of the present invention,
FIG. 6 is a block diagram of a signal reception circuit according to a first structural example of a fifth embodiment of the present invention,
FIG. 7 is a diagram for explaining an operation of a signal reception circuit according to the fifth embodiment of the present invention,
FIG. 8 is a block diagram of a signal reception circuit according to a second structural example of the fifth embodiment of the present invention,
FIG. 9 is a block diagram of a signal reception circuit according to a third structural example of the fifth embodiment of the present invention,
FIG. 10 is a block diagram of a signal reception circuit according to a sixth embodiment of the present invention,
FIG. 11 is a block diagram of a conventional circuit in which a current is shared among a plurality of circuit blocks,
FIG. 12 is a block diagram of a conventional folded load downconverter circuit, and
FIGS. 13A and 13B are characteristics diagrams of a conventional folded load downconverter circuit.

### DESCRIPTION OF THE PREFERRED EMBODIMENTS

Hereinafter, first to sixth embodiments of the present invention will be described with reference to the accompanying drawings. In the first to fourth embodiments, a signal reception front-end circuit will be described. In the fifth embodiment, a signal reception circuit comprising the signal reception front-end circuit of the first or second embodiment will be described. In the sixth embodiment, a signal reception circuit comprising the signal reception front-end circuit of the third or fourth embodiment will be described. In the following description, among the components of each embodiment, the same components as those which have been heretofore described are indicated with the same reference numerals, and will not be explained.

### (First embodiment)

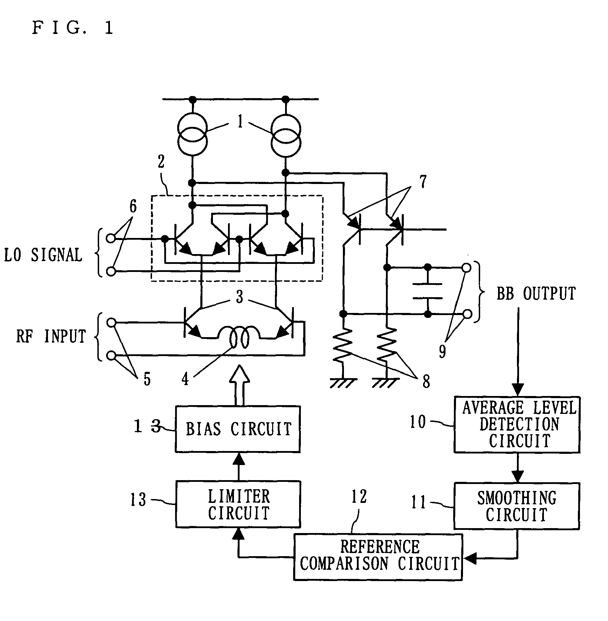

FIG. 1 is a block diagram showing a structure of a signal reception front-end circuit according to the first embodiment of the present invention. The signal reception front-end circuit of FIG. 1 comprises a constant current source 1 of a folded current mirror circuit, an upper transistor 2 of a Gilbert mixer circuit, a lower transistor 3 of the Gilbert mixer circuit, an emitter inductor 4 of the Gilbert mixer circuit, a signal input terminal 5, a local signal input terminal 6, a secondary transistor 7 of the folded current mirror circuit, a load circuit 8, an IF output terminal 9, an average level detection circuit 10, a smoothing circuit 11, a reference comparison circuit 12, a limiter circuit 13, and a bias circuit 14.

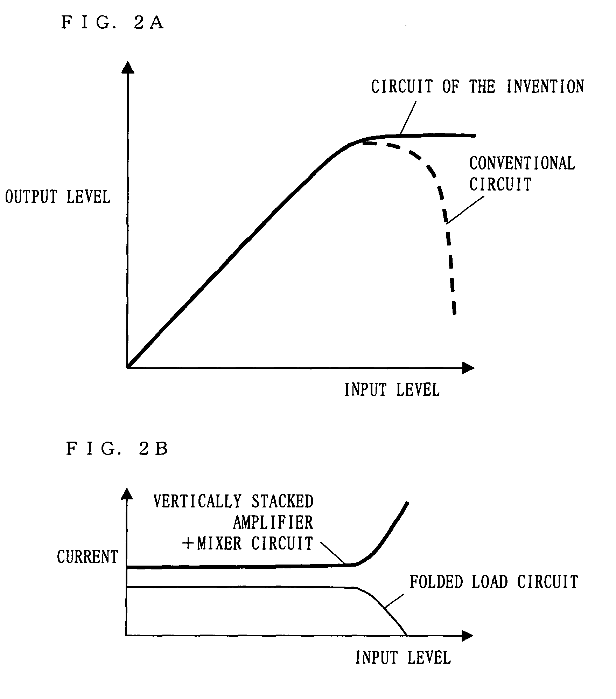

Characteristics of the signal reception front-end circuit of FIG. 1 will be described with reference to FIGS. 2A and 2B. FIG. 2A shows an IF output level with respect to an input level. FIG. 2B shows currents consumed by the mixer circuit and the folded load circuit with respect to the input level. Note that FIG. 2A also shows characteristics of a conventional circuit.

As shown in FIG. 2B, a current flowing through the mixer circuit increases under an unexpectedly strong input condition to a higher level than during an ordinary operation. On the other hand, the sum of a current flowing through the mixer circuit and a current flowing through the folded load circuit is always kept constant by an action of the folded current mirror circuit. Therefore, under the unexpectedly strong input condition, the current consumed by the folded load circuit decreases. As a result, in the conventional circuit, the current flowing through the folded load circuit approaches zero. In this case, the circuit malfunctions, resulting in a significant decrease in the IF output level as indicated with a dashed line in FIG. 2A.

In order to prevent such a decrease in the IF output level, the signal reception front-end circuit of the first embodiment comprises the average level detection circuit 10, the smoothing circuit 11, the reference comparison circuit 12, the limiter circuit 13, and the bias circuit 14. The average level detection circuit 10 is connected to an output of the load circuit 8 to detect an average AC amplitude level of a baseband output signal (indicated by "BB output" in FIG. 1) output from the signal reception front-end circuit. The smoothing circuit 11 removes an AC component from an output signal of the average level detection circuit 10. The reference comparison circuit 12 compares an output signal of the smoothing circuit 11 with a predetermined reference voltage. When the output signal of the smoothing circuit 11 exceeds the reference voltage, the reference comparison circuit 12 outputs a level suppression signal. The limiter circuit 13 and the bias circuit 14 function as a bias control circuit. The bias circuit 14 supplies a bias current to the mixer circuit. When the level suppression signal is output from the reference comparison circuit 12, the limiter circuit 13 controls the bias circuit 14 to suppress the bias current of the mixer circuit below a predetermined level.

Thus, in the signal reception front-end circuit of FIG. 1, when the IF output level increases in association with an increase in the input level, the bias current of the mixer circuit is suppressed below the predetermined level. Therefore, even if the input level is increased, the circuit does not malfunction and the IF output level does not decrease, as is different from conventional circuits (see FIG. 2A).

As described above, in the signal reception front-end circuit of the first embodiment, a current flowing through the folded load circuit does not become zero under an unexpectedly strong input condition. Therefore, it is possible to obtain a low-current-consumption signal reception front-end circuit in which the IF output level does not significantly decrease under an unexpectedly strong input condition.

### (Second embodiment)

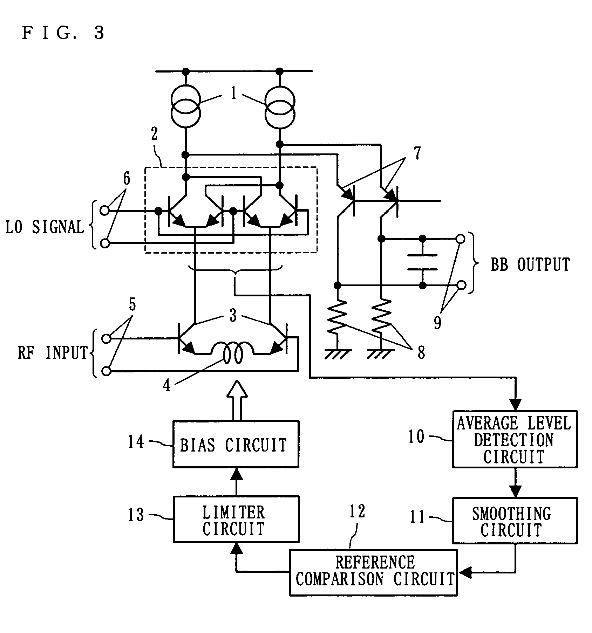

FIG. 3 is a block diagram showing a signal reception front-end circuit according to the second embodiment of the present invention. The signal reception front-end circuit of FIG. 3 comprises the same components as those of the signal reception front-end circuit of the first embodiment (FIG. 1). Note that the average level detection circuit 10 is connected to an input of the mixer circuit, but not to the output of the load circuit 8. The average level detection circuit 10 detects an average AC amplitude level of an input signal of the mixer circuit. The components other than the average level detection circuit 10 operate in a manner similar to those of the signal reception front-end circuit of the first embodiment. The signal reception front-end circuit of the second embodiment has an effect similar to that of the signal reception front-end circuit of the first embodiment.

### (Third embodiment)

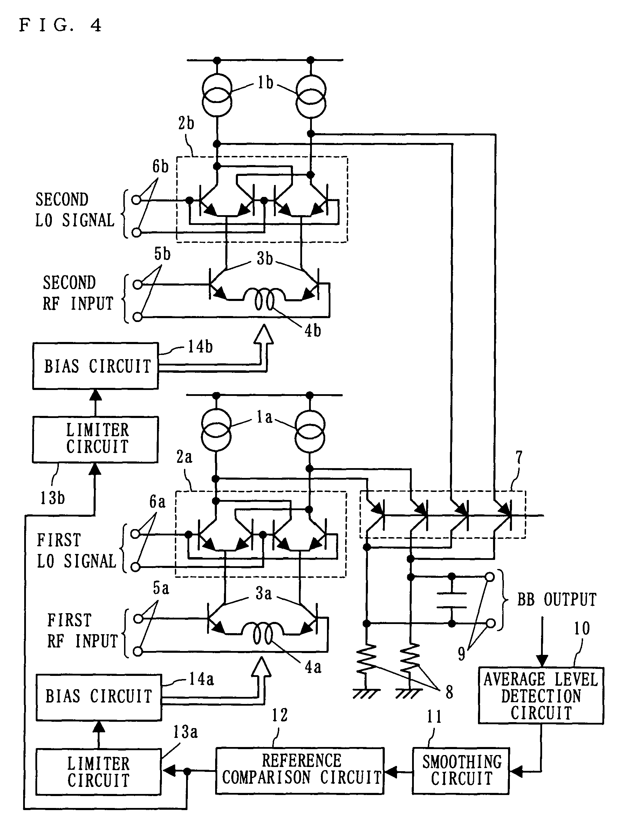

FIG. 4 is a block diagram showing a signal reception front-end circuit according to the third embodiment of the present invention. The signal reception front-end circuit of FIG. 4 is a variation of the signal reception front-end circuit of the first embodiment (FIG. 1) which processes two received signals. The signal reception front-end circuit comprises constant current sources 1a and 1b of a folded current mirror circuit, upper transistors 2a and 2b of a Gilbert mixer circuit, lower transistors 3a and 3b of the Gilbert mixer circuit, emitter inductors 4a and 4b of the Gilbert mixer circuit, signal input terminals 5a and 5b, local signal input terminals 6a and 6b, a secondary transistor 7 of the folded current mirror circuit, a load circuit 8, an IF output terminal 9, an average level detection circuit 10, a smoothing circuit 11, a reference comparison circuit 12, limiter circuits 13a and 13b, and bias circuits 14a and 14b.

Among these components, the constant current source 1a of the folded current mirror circuit, the upper transistor 2a of the Gilbert mixer circuit, the lower transistor 3a of the Gilbert mixer circuit, and the emitter inductor 4a of the Gilbert mixer circuit, constitute a first mixer circuit. The constant current source 1b of the folded current mirror circuit, the upper transistor 2b of the Gilbert mixer circuit, the lower transistor 3b of the Gilbert mixer circuit, and the emitter inductor 4b of the Gilbert mixer circuit, constitute a second mixer circuit. The signal input terminal 5a and the local signal input terminal 6a are input terminals of the first mixer circuit. The limiter circuit 13a and the bias circuit 14a are provided for the first mixer circuit. The signal input terminal 5b and the local signal input terminal 6b are input terminals of the second mixer circuit. The limiter circuit 13b and the bias circuit 14b are provided for the second mixer circuit.

The first mixer circuit and the second mixer circuit operate exclusively to each other. When the first mixer circuit operates while the second mixer circuit stops its operation, the average level detection circuit 10 detects an average AC amplitude level of a baseband output signal if a received signal is input to the first mixer circuit. The smoothing circuit 11 and the reference comparison circuit 12 operate as in the signal reception front-end circuit of the first embodiment. The bias circuit 14a supplies a bias current to the first mixer circuit. When a level suppression signal is output from the reference comparison circuit 12, the limiter circuit 13a controls the bias circuit 14a to suppress the bias current of the first mixer circuit below a predetermined level. Therefore, even if an unexpectedly strong signal is input to the first mixer circuit, a current flowing through the folded load circuit does not become zero, so that the IF output level does not decrease significantly.

Conversely, when the second mixer circuit operates while the first mixer circuit stops its operation, the average level detection circuit 10 detects the average AC amplitude level of the baseband output signal if a received signal is input to the second mixer circuit. The smoothing circuit 11 and the reference comparison circuit 12 operate as in the signal reception front-end circuit of the first embodiment. The bias circuit 14b supplies a bias current to the second mixer circuit. When the reference comparison circuit 12 outputs a level suppression signal, the limiter circuit 13b controls the bias circuit 14b to suppress the bias current of the second mixer circuit below a predetermined level. Therefore, even if an unexpectedly strong signal is input to the second mixer circuit, a current flowing through the folded load circuit does not become zero, so that the IF output level does not decrease significantly.

Thus, the signal reception front-end circuit of FIG. 4 comprises the two mixer circuits corresponding to a plurality of bands, and the single folded load circuit shared by the two mixer circuits. Even if an unexpectedly strong signal is input to any of the two mixer circuit, the current of the folded load circuit does not become zero, so that the IF output level does not decrease significantly.

As described above, the signal reception front-end circuit of the third embodiment comprises a plurality of mixer circuits. Even if an unexpectedly strong signal is input to any of the mixer circuits, a current flowing through the folded load circuit does not become zero. Therefore, it is possible to obtain a low-current-consumption signal reception front-end circuit which comprises a plurality of mixer circuits and can avoid a significant decrease in IF output level under an unexpectedly strong input condition.

### (Fourth embodiment)

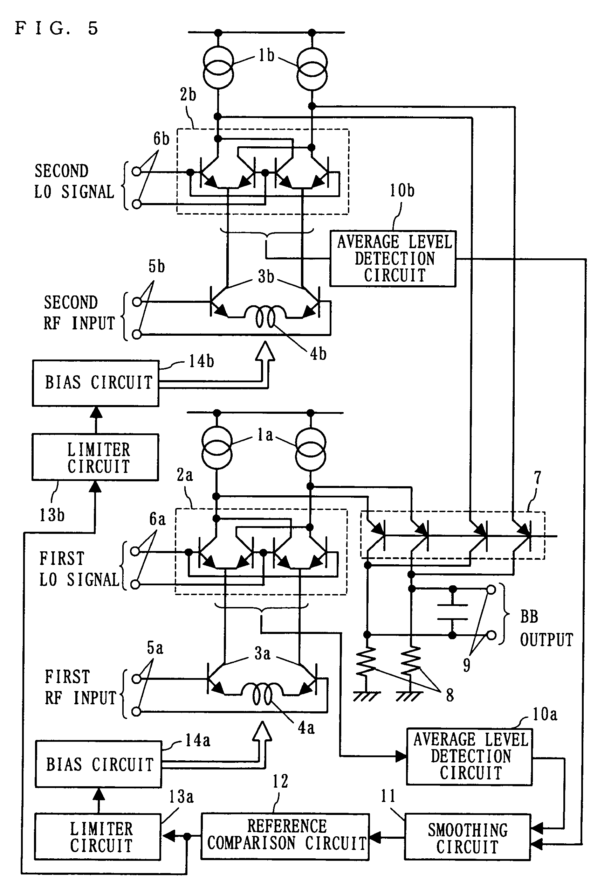

FIG. 5 is a block diagram showing a structure of a signal reception front-end circuit according to the fourth embodiment of the present invention. The signal reception front-end circuit of FIG. 5 comprises an average level detection circuit 10b in addition to the components of the signal reception front-end circuit of the third embodiment (FIG. 4). The average level detection circuit 10a for the first mixer circuit is connected to an input of the first mixer circuit, but not to an output of the load circuit 8. The average level detection circuit 10b for the second mixer circuit is connected to an input of the second mixer circuit.

As in the third embodiment, the signal reception front-end circuit of FIG. 5 comprises the first and second mixer circuits. The average level detection circuits 10a and 10b detect average AC amplitude levels of signals input to the first and second mixer circuits, respectively.

The first mixer circuit and the second mixer circuit operate exclusively to each other. When the first mixer circuit operates while the second mixer circuit stops its operation, the smoothing circuit 11 removes an AC component from an output signal of the average level detection circuit 10a, and the reference comparison circuit 12, the limiter circuit 13a, and the bias circuit 14a operate as in the signal reception front-end circuit of the third embodiment. Therefore, even if an unexpectedly strong signal is input to the first mixer circuit, a current of the folded load circuit does not become zero, so that the IF output level does not decrease significantly.

Conversely, when the second mixer circuit operates while the first mixer circuit stops its operation, the smoothing circuit 11 removes an AC component from an output signal of the average level detection circuit 10b, and the reference comparison circuit 12, the limiter circuit 13b, and the bias circuit 14b operate as in the signal reception front-end circuit of the third embodiment. Therefore, even if an unexpectedly strong signal is input to the second mixer circuit, a current of the folded load circuit does not become zero, so the IF output level does not decrease significantly.

As described above, the signal reception front-end circuit of the fourth embodiment comprises a plurality of mixer circuits. Even if an unexpectedly strong signal is input to any of the mixer circuits, a current flowing through the folded load circuit does not become zero. Therefore, the signal reception front-end circuit of the fourth embodiment has an effect similar to that of the signal reception front-end circuit of the third embodiment.

Note that various variations of the first to fourth embodiments can be provided as follows. The signal reception front-end circuit of each of the above-described embodiments comprises a limiter circuit which prevents an increase in bias current of a mixer circuit. Instead of the limiter circuit, a current control circuit which increase a current flowing through the folded current mirror circuit by an increment of a current flowing through a mixer circuit, may be provided. The thus-constructed signal reception front-end circuit has an effect similar to that of the signal reception front-end circuit of each of the above-described embodiments.

The signal reception front-end circuit of each of the above-described embodiments comprises an average level detection circuit which detects an average AC amplitude level of a signal. However, a major factor which is responsible for a decrease in IF output level is that a current of a folded load circuit decreases in association with an increase in current of a mixer circuit. Therefore, the signal reception front-end circuit may comprise a detection circuit which detects a DC level of a signal or a detection circuit which detects both an average AC amplitude level and a DC level of a signal, instead of the detection circuit which detects the average AC amplitude level of a signal. The thus-constructed signal reception front-end circuit has an effect similar to that of the signal reception front-end circuit of each of the above-described embodiments.

The signal reception front-end circuit of each of the embodiments comprises a Gilbert mixer circuit as a mixer circuit. Instead of this, another type of mixer circuit which has a property such that a current increases under a strong input condition, may be provided. The thus-constructed signal reception front-end circuit has an effect similar to that of the signal reception front-end circuit of each of the above-described embodiments.

In the signal reception front-end circuit of each of the embodiments, the reference comparison circuit may switch the reference voltage among a plurality of levels. In the thus-constructed signal reception front-end circuit, a current control value of the limiter circuit can be switched or a cut-off frequency of the smoothing circuit can be switched, depending on switching of the reference voltage. Particularly, in the signal reception front-end circuits of the third and fourth embodiments, the current control value of the limiter circuit can be switched for each mixer circuit. Therefore, the signal reception front-end circuit which switches the reference voltage among a plurality of levels has an additional effect, such as an improvement in response speed or the like, in addition to the effects of the signal reception front-end circuit of each of the embodiments.

### (Fifth embodiment)

In the fifth embodiment, three signal reception circuits (hereinafter referred to as first to third structural examples), each of which comprises the signal reception front-end circuit of the first or second embodiment, will be described.

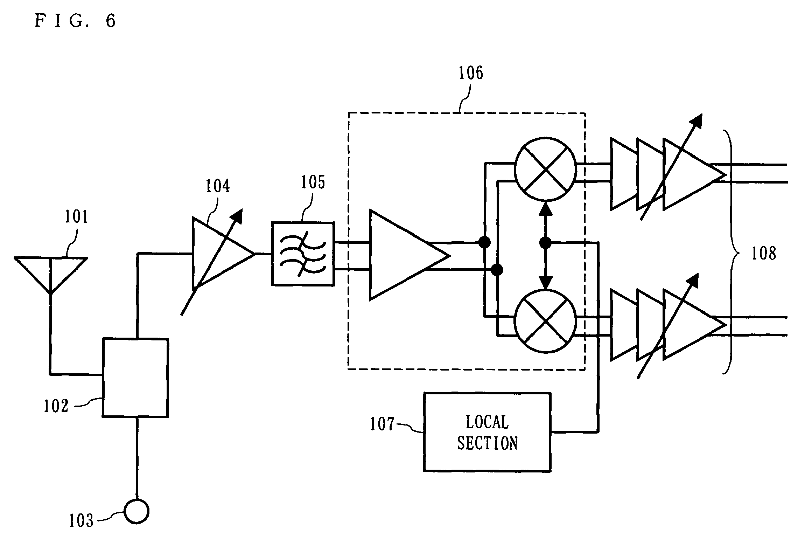

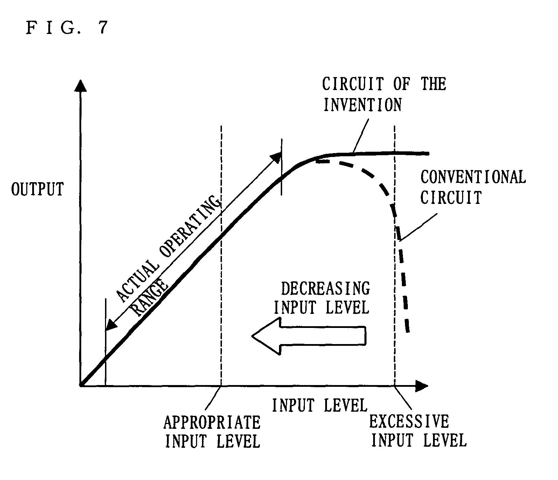

FIG. 6 is a block diagram showing a structure of a signal reception circuit according to the first structural example of the fifth embodiment. The signal reception circuit of FIG. 6 comprises a variable gain amplifier 104, a filter 105, a signal reception front-end circuit 106, a local section 107, and an IF variable gain circuit 108. The signal reception circuit, an antenna 101, an antenna-sharing circuit 102, and a transmission circuit (not shown) which is connected to a transmission terminal 103, constitute a wireless communication section of a communication apparatus. As the signal reception front-end circuit 106, the signal reception front-end circuit of the first or second embodiment is used. FIG. 7 is a diagram in which an explanation for a gain operation of the signal reception circuit of FIG. 6 is added to FIG. 2A.

In general, the signal reception circuit regulates a gain setting of the whole signal reception circuit, depending on a level of an input signal, thereby keeping the IF output level constant. However, when a mobile communication apparatus is in an initial state when powered on or is moved from behind a building to a place within sight of a base station, the mobile communication apparatus may receive an unexpectedly strong signal. Under such an unexpectedly strong input condition, conventional circuits erroneously further increase the gain of the signal reception circuit so as to keep the IF output level constant as indicated with a dashed line in FIG. 7.

In contrast to this, the signal reception circuit of FIG. 6 comprises the signal reception front-end circuit of the first or second embodiment as the signal reception front-end circuit 106. When the signal reception front-end circuit of the first or second embodiment is used, the IF output level does not decrease significantly under the unexpectedly strong input condition. Therefore, as indicated with an open arrow in FIG. 7, by reducing a gain of the variable gain amplifier 104, an excessive input level can be lowered to an appropriate input level. This gain reduction process is preferably performed during a time when the signal reception front-end circuit 106 suppresses a bias.

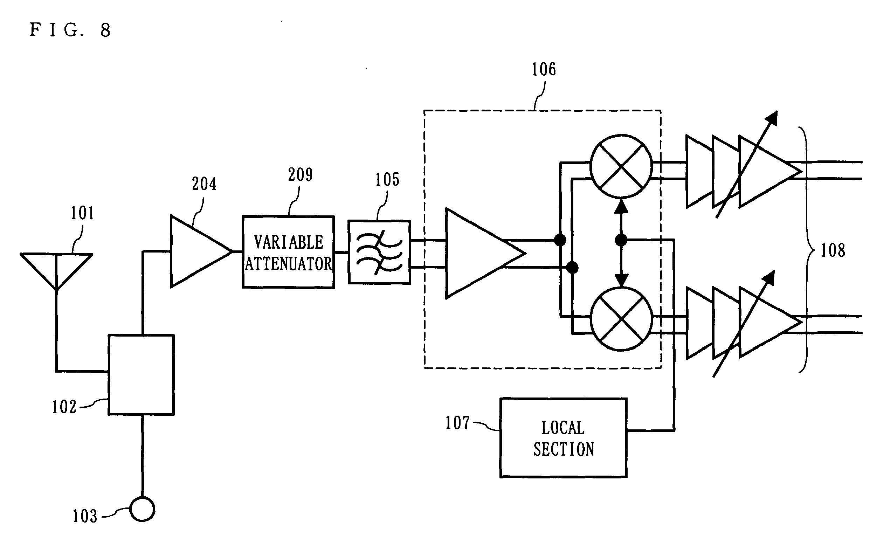

FIG. 8 is a block diagram showing a structure of a signal reception circuit according to the second structural example of the second embodiment. The signal reception circuit of FIG. 8 is the same as the signal reception circuit of the first structural example (FIG. 6), except that the variable gain amplifier 104 is replaced with a fixed gain amplifier 204 and a variable attenuator 209. In the signal reception circuit of FIG. 8, by increasing an amount of attenuation by the variable attenuator 209, an excessive input level can be lowered to an appropriate input level as in the signal reception circuit of the first structural example. Therefore, the signal reception circuit of FIG. 8 has an effect similar to that of the signal reception circuit of the first structural example.

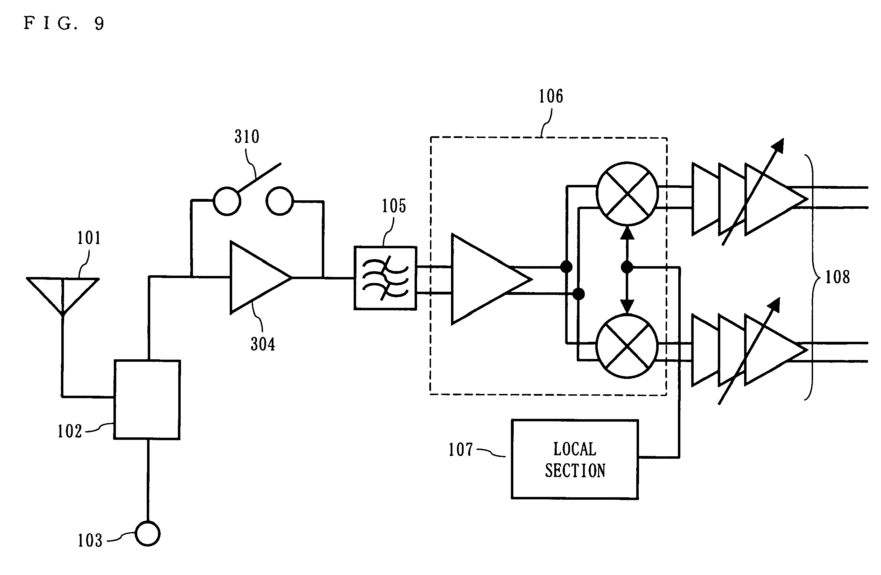

FIG. 9 is a block diagram showing a structure of a signal reception circuit according to the third structural example of the fifth embodiment. The signal reception circuit of FIG. 9 is the same as the signal reception circuit (FIG. 6) of the first structural example, except that the variable gain amplifier 104 is replaced with a fixed gain amplifier 304 and a bypass circuit 310. In the signal reception circuit of FIG. 9, a bias of the amplifier 304 is interrupted so that the bypass circuit 310 is controlled to be conductive, thereby making it possible to lower an excessive input level to an appropriate input level, as in the signal reception circuits of the first and second structural examples. Therefore, the signal reception circuit of FIG. 9 has an effect similar to that of the signal reception circuits of the first and second structural examples.

As described above, the signal reception circuits of the fifth embodiment can lower an excessive input level to an appropriate input level. Therefore, it is possible to obtain a low-current-consumption signal reception circuit which does not malfunction under an unexpectedly strong input condition and in which an error does not occur in signal reception level detection.

### (Sixth embodiment)

In the sixth embodiment, a signal reception circuit comprising the signal reception front-end circuit of the third or fourth embodiment will be described.

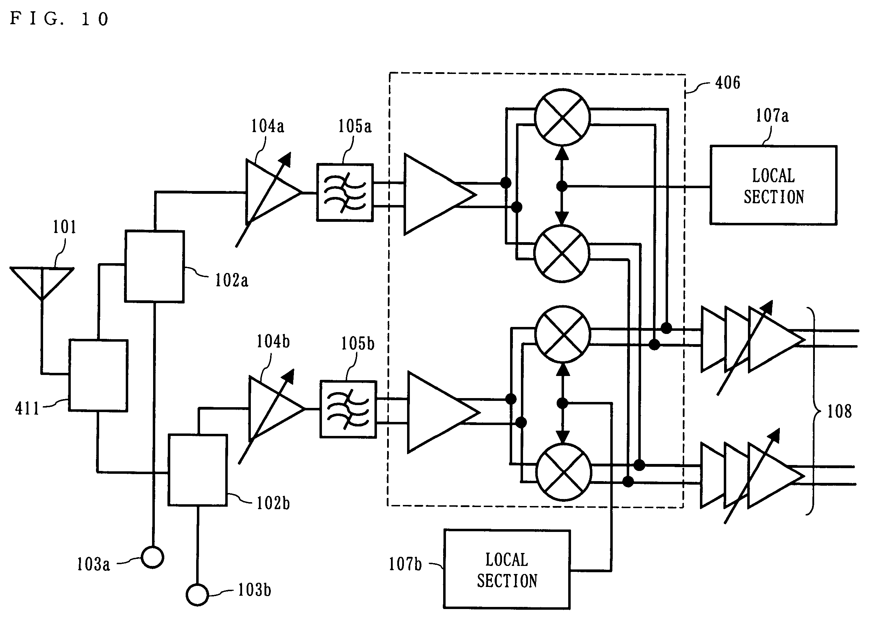

FIG. 10 is a block diagram showing a structure of the signal reception circuit of the sixth embodiment. The signal reception circuit of FIG. 10 comprises variable gain amplifiers 104a and 104b, filters 105a and 105b, a signal reception front-end circuit 406, local sections 107a and 107b, and an IF variable gain circuit 108. The signal reception circuit, an antenna 101, antenna-sharing circuits 102a and 102b, two transmission circuits (not shown) which are connected to transmission terminals 103a and 103b, and a switch 411, constitute a wireless communication section of a communication apparatus. As the signal reception front-end circuit 406, the signal reception front-end circuit of the third or fourth embodiment is used.

Note that the signal reception circuit of FIG. 10 may comprise a fixed gain amplifier and a variable attenuator, or a fixed gain amplifier and a bypass circuit, as described in the fifth embodiment, instead of the variable gain amplifiers 104a and 104b.

It will be clearly understood from the descriptions of the third to fifth embodiments that the signal reception circuit of FIG. 10 and variations thereof have an effect similar to that of the signal reception circuit of the fifth embodiment. Therefore, according to the sixth embodiment, it is possible to obtain a low-current-consumption signal reception circuit in which a plurality of received signals can be handled, malfunction can be avoided under an unexpectedly strong input condition, and an error does not occur in signal reception level detection.

Note that, in the signal reception circuit of the fifth and sixth embodiments, when an input level is reduced in the variable amplifier, the variable attenuator or the bypass circuit, the IF variable gain circuit may increase a gain corresponding to an amount of the reduction. The thus-constructed signal reception circuit can perform a more accurate reception operation.

The signal reception front-end circuit and the signal reception circuit of the present invention can be useful for various communication apparatuses, such as a mobile communication apparatus and the like, since the IF output level is not significantly lowered under an unexpectedly strong input condition.

While the invention has been described in detail, the foregoing description is in all aspects illustrative and not restrictive. It is understood that numerous other modifications and variations can be devised without departing from the scope of the invention.

## Claims

1. A signal reception front-end circuit for use in a signal reception circuit of a communication apparatus, comprising:
a folded load downconverter circuit comprising a mixer circuit (2, 3, 4), a current mirror circuit (1, 7) and a load circuit (8), wherein the current mirror circuit folds an output of the mixer circuit, and the load circuit is connected to a folded output of the current mirror circuit;
a detection circuit (10) of detecting an input signal or an output signal of the folded load downconverter circuit;
a smoothing circuit (11) of smoothing an output signal of the detection circuit;
a reference comparison circuit (12) of comparing an output signal of the smoothing circuit with a predetermined reference voltage; and
a bias control circuit (13, 14) of controlling a bias of the folded load downconverter circuit, depending on a result of comparison by the reference comparison circuit.

2. The signal reception front-end circuit according to claim 1, wherein the bias control circuit (13, 14) controls a bias of the mixer circuit (2, 3, 4).

3. The signal reception front-end circuit according to claim 1, wherein the bias control circuit controls a bias of the current mirror circuit (1, 7).

4. The signal reception front-end circuit according to claim 1, wherein the detection circuit (10) is connected to an input of the mixer circuit (2, 3, 4).

5. The signal reception front-end circuit according to claim 1, wherein the detection circuit (10) is connected to an output of the load circuit (8).

6. The signal reception front-end circuit according to claim 1, wherein the detection circuit (10) detects an AC amplitude of a signal.

7. The signal reception front-end circuit according to claim 1, wherein the detection circuit detects a DC level of a signal.

8. The signal reception front-end circuit according to claim 1, wherein the detection circuit detects both an AC amplitude and a DC level of a signal.

9. The signal reception front-end circuit according to claim 1, wherein the reference voltage is switched among a plurality of levels.

10. The signal reception front-end circuit according to claim 9, wherein, when the reference voltage is switched, a cut-off frequency of the smoothing circuit (11) is switched.

11. The signal reception front-end circuit according to claim 1, wherein:
the folded load downconverter circuit is a multiple-input single-output circuit comprising the load circuit (8), a plurality of the mixer circuits (2a, 2b, 3a, 3b, 4a, 4b) and a plurality of the current mirror circuits (1a, 1b, 7a, 7b), wherein the current mirror circuits fold outputs of the respective mixer circuits, folded outputs of the current mirror circuits are connected to a common output, and the load circuit is connected to the common output;
the signal reception front-end circuit comprises a plurality of the bias control circuits (13a, 13b, 14a, 14b); and
the bias control circuits control biases of the respective folded load downconverter circuits provided for input signals.

12. The signal reception front-end circuit according to claim 11, wherein the bias control circuits (13a, 13b, 14a, 14b) control biases of the respective mixer circuits (2a, 2b, 3a, 3b, 4a, 4b).

13. The signal reception front-end circuit according to claim 11, wherein the bias control circuits controls biases of the respective current mirror circuits (1a, 1b, 7a, 7b).

14. The signal reception front-end circuit according to claim 11, wherein:
the signal reception front-end circuit comprises a plurality of the detection circuits (10a, 10b); and
the detection circuits are connected to inputs of the respective mixer circuits (2a, 2b, 3a, 3b, 4a, 4b).

15. The signal reception front-end circuit according to claim 11, wherein the detection circuit (10) is connected to an output of the load circuit (8).

16. A signal reception circuit for use in a communication apparatus, comprising:
a gain switch circuit (104, 209, 304, 310) of regulating a level of a received signal; and
a signal reception front-end circuit connected to an output of the gain switch circuit,
wherein the signal reception front-end circuit comprises:
a folded load downconverter circuit comprising a mixer circuit (2, 3, 4), a current mirror circuit (1, 7) and a load circuit (8), wherein the current mirror circuit folds an output of the mixer circuit, and the load circuit is connected to a folded output of the current mirror circuit;
a detection circuit (10) of detecting an input signal or an output signal of the folded load downconverter circuit;
a smoothing circuit (11) of smoothing an output signal of the detection circuit;
a reference comparison circuit (12) of comparing an output signal of the smoothing circuit with a predetermined reference voltage; and
a bias control circuit (13, 14) of controlling a bias of the folded load downconverter circuit, depending on a result of comparison by the reference comparison circuit.

17. The signal reception circuit according to claim 16, wherein a gain of the gain switch circuit (104, 209, 304, 310) is switched to a low value during a time when the bias control circuit (13, 14) suppresses a bias.

18. The signal reception circuit according to claim 16, wherein the gain switch circuit comprises a variable gain amplifier (104).

19. The signal reception circuit according to claim 16, wherein the gain switch circuit comprises a variable attenuator (209).

20. The signal reception circuit according to claim 16, wherein the gain switch circuit comprises a fixed gain amplifier (304), and a bypass circuit (310) of causing a signal to bypass the fixed gain amplifier in the case of a low gain.

21. The signal reception circuit according to claim 16, further comprising a variable gain amplifier (105) of amplifying an output signal of the signal reception front-end circuit,
wherein a gain of the variable gain amplifier is switched with the same timing as a timing with which a gain of the gain switch circuits (104, 209, 304, 310) is changed.

22. The signal reception circuit according to claim 16, wherein:
the signal reception circuit comprises a plurality of the gain switch circuits (104a, 104b);
the folded load downconverter circuit is a multiple-input single-output circuit comprising the load circuit (8), a plurality of the mixer circuits (2a, 2b, 3a, 3b, 4a, 4b) and a plurality of the current mirror circuits (1a, 1b, 7a, 7b), wherein the current mirror circuits fold outputs of the respective mixer circuits, folded outputs of the current mirror circuits are connected to a common output, and the load circuit is connected to the common output;
the signal reception front-end circuit comprises a plurality of the bias control circuits (13a, 13b, 14a, 14b); and
the bias control circuits control biases of the respective folded load downconverter circuits provided for input signals.

23. The signal reception circuit according to claim 22, wherein at least one of the gain switch circuits comprises a variable gain amplifier (104).

24. The signal reception circuit according to claim 22, wherein at least one of the gain switch circuits comprises a variable attenuator (209).

25. The signal reception circuit according to claim 22, wherein at least one of the gain switch circuits comprises a fixed gain amplifier (304), and a bypass circuit (310) of causing a signal to bypass the fixed gain amplifier in the case of a low gain.

26. A communication apparatus for performing wireless communication, comprising:
an antenna(101) of transmitting/receiving a radio wave;
an antenna-sharing circuit (102) connected to the antenna;
a transmission circuit connected to the antenna-sharing circuit; and
a signal reception circuit connected to the antenna-sharing circuit,
wherein the signal reception circuit comprises:
a gain switch circuit (104, 209, 304, 310) of regulating a level of a received signal output from the antenna-sharing circuit; and
a signal reception front-end circuit connected to an output of the gain switch circuit,
wherein the signal reception front-end circuit comprises:
a folded load downconverter circuit comprising a mixer circuit (2, 3, 4), a current mirror circuit (1, 7) and a load circuit (8), wherein the current mirror circuit folds an output of the mixer circuit, and the load circuit is connected to a folded output of the current mirror circuit;
a detection circuit (10) of detecting an input signal or an output signal of the folded load downconverter circuit;
a smoothing circuit (11) of smoothing an output signal of the detection circuit;
a reference comparison circuit (12) of comparing an output signal of the smoothing circuit with a predetermined reference voltage; and
a bias control circuit (13, 14) of controlling a bias of the folded load downconverter circuit, depending on a result of comparison by the reference comparison circuit.

27. The communication apparatus according to claim 26, wherein:
the signal reception circuit comprises a plurality of the gain switch circuits (104a, 104b);
the folded load downconverter circuit is a multiple-input single-output circuit comprising the load circuit (8), a plurality of the mixer circuits (2a, 2b, 3a, 3b, 4a, 4b) and a plurality of the current mirror circuits (1a, 1b, 7a, 7b), wherein the current mirror circuits fold outputs of the respective mixer circuits, folded outputs of the current mirror circuits are connected to a common output, and the load circuit is connected to the common output;
the signal reception front-end circuit comprises a plurality of the bias control circuits (13a, 13b, 14a, 14b); and
the bias control circuits control biases of the respective folded load downconverter circuits provided for input signals.
